# EUROPEAN PATENT SPECIFICATION

(11) **EP 4 529 142 B1**
(45) Date of publication and mention of the grant of the patent: **05.08.2026**
(21) Application number: 23839776.4
(22) Date of filing: 16.05.2023
(51) Int. Cl.: H04M 1/02, H04M 1/18, H05K 5/00, H05K 5/03

(54) **COVER WINDOW AND ELECTRONIC DEVICE COMPRISING SAME**
ABDECKFENSTER UND ELEKTRONISCHE VORRICHTUNG DAMIT
FENÊTRE DE RECOUVREMENT ET DISPOSITIF ÉLECTRONIQUE COMPRENANT CELLE-CI

(30) Priority: 13.07.2022 KR 20220086151; 29.08.2022 KR 20220108285
(43) Date of publication of application: 26.03.2025
(73) Proprietor: Samsung Electronics Co., Ltd., Suwon-si, Gyeonggi-do 16677 (KR)
(72) Inventor: MOON, Youngmin, Suwon-si, Gyeonggi-do 16677 (KR); BAE, Jaehyun, Suwon-si, Gyeonggi-do 16677 (KR); SHIN, Chulsoo, Suwon-si, Gyeonggi-do 16677 (KR); SEO, Bobum, Suwon-si, Gyeonggi-do 16677 (KR); LEE, Changsu, Suwon-si, Gyeonggi-do 16677 (KR)
(74) Representative: Gulde & Partner
(86) International application number: PCT/KR2023/006627
(87) International publication number: WO 2024/014682

(56) References cited:
- KR-A- 20180 062 249
- KR-A- 20180 062 272
- KR-A- 20200 033 001
- KR-B1- 102 068 729
- KR-B1- 102 246 919

## Description

### [Technical Field]

Various embodiments disclosed herein relate to an electronic device, and relates to, for example, a cover window and an electronic device including the same.

### [Background Art]

Due to advancement in information and communication technology and semiconductor technology, various functions are being integrated into a single portable electronic device. For example, an electronic device may implement not only communication functions, but also entertainment functions such as gaming, multimedia functions such as music/video playback, communication and security functions for mobile banking, and functions for schedule management and/or an electronic wallet function. These electronic devices are being miniaturized to be conveniently carried by users.

As mobile communication service extends into the multimedia service domain, it is necessary to increase the display sizes of electronic devices in order to allow users to fully utilize multimedia services, as well as voice call and short message services. However, the display sizes of electronic devices are in a trade-off relationship with the miniaturization of electronic devices.

### [Detailed Description of the Invention]

### [Technical Solution]

According to the invention, an electronic device includes a housing having a first housing and a second housing configured to provide a relative movement with respect to the first housing, a hinge structure connecting the first housing and the second housing to be rotatable from a folded state to an unfolded state, a flexible display configured to vary in response to relative movement of the first housing with respect to the second housing, and a cover window configured to cover an outer surface of the flexible display. The cover window includes a first glass disposed corresponding to the first housing, a second glass disposed corresponding to the second housing, a protective layer disposed outside the first glass and the second glass, and a transparent resin layer filled between the protective layer and the flexible display. The transparent resin layer includes plurality of first transparent areas spaced apart from each other in a direction from the first glass to the second glass, and plurality of second transparent areas disposed between the plurality of first transparent areas. The hardness of the plurality of first transparent areas is greater than hardness of the plurality of second transparent areas.

According to an embodiment of the disclosure, an electronic device may include a housing having a first housing and a second housing configured to provide a relative movement with respect to the first housing, a hinge structure connecting the first housing and the second housing to be rotatable from a folded state to an unfolded state, a flexible display configured to vary in response to relative movement of the first housing with respect to the second housing, and a cover window configured to cover an outer surface of the flexible display. The cover window may include a first glass disposed corresponding to the first housing, a second glass disposed corresponding to the second housing, a protective layer disposed outside the first glass and the second glass, and a transparent resin layer filled between the protective layer and the flexible display. The transparent resin layer may include plurality of first transparent areas spaced apart from each other in a direction from the first glass to the second glass, and plurality of second transparent areas disposed between the plurality of first transparent areas. The maximum interval among the intervals between the plurality of first transparent areas may be 1.0 mm or less.

According to an embodiment of the disclosure, a cover window configured to be laminated on one surface of a display may include a first glass, a second glass spaced apart from the first glass, and a protective layer disposed outside the first glass and the second glass, and a transparent resin layer configured to bond the first glass and the second glass to the protective layer. The transparent resin layer may include plurality of first transparent areas spaced apart from each other in a direction from the first glass toward the second glass, and plurality of second transparent areas disposed between the plurality of first transparent areas. The hardness of the plurality of first transparent areas may be greater than hardness of the plurality of second transparent areas.

### [Brief Description of Drawings]

FIG. 1 is a block diagram of an electronic device according to various embodiments in a network environment.
FIG. 2 is a view illustrating an electronic device according to an embodiment of the disclosure in an unfolded state.
FIG. 3 is a view illustrating the electronic device according to an embodiment of the disclosure in the folded state.
FIG. 4 is an exploded perspective view of the electronic device according to an embodiment of the disclosure.
FIG. 5A is a cross-sectional view illustrating a display and a cover window according to an embodiment of the disclosure in the unfolded state.
FIG. 5B is a cross-sectional view illustrating the display and the cover window according to an embodiment of the disclosure in the folded state.
FIG. 6A is an enlarged view of the portion "B" of FIG. 5A, according to an embodiment of the disclosure.
FIG. 6B is an enlarged view of the portion "B" of FIG. 5A, according to an embodiment of the disclosure.
FIG. 6C is an enlarged view of the portion "B" of FIG. 5A, according to an embodiment of the disclosure.
FIG. 6D is an enlarged view of the portion "B" of FIG. 5A, according to an embodiment of the disclosure.
FIGS. 7A, 7B, 7C, 7D, and 7E are views illustrating a process of manufacturing a cover window according to an embodiment of the disclosure.
FIG. 8 is a cross-sectional view illustrating a display and a cover window according to an embodiment of the disclosure in the unfolded state.
FIG. 9 is a cross-sectional view illustrating a display and a cover window according to an embodiment of the disclosure in the unfolded state.
FIG. 10 is a cross-sectional view illustrating a display and a cover window according to an embodiment of the disclosure in the unfolded state.

### [Mode for Carrying out the Invention]

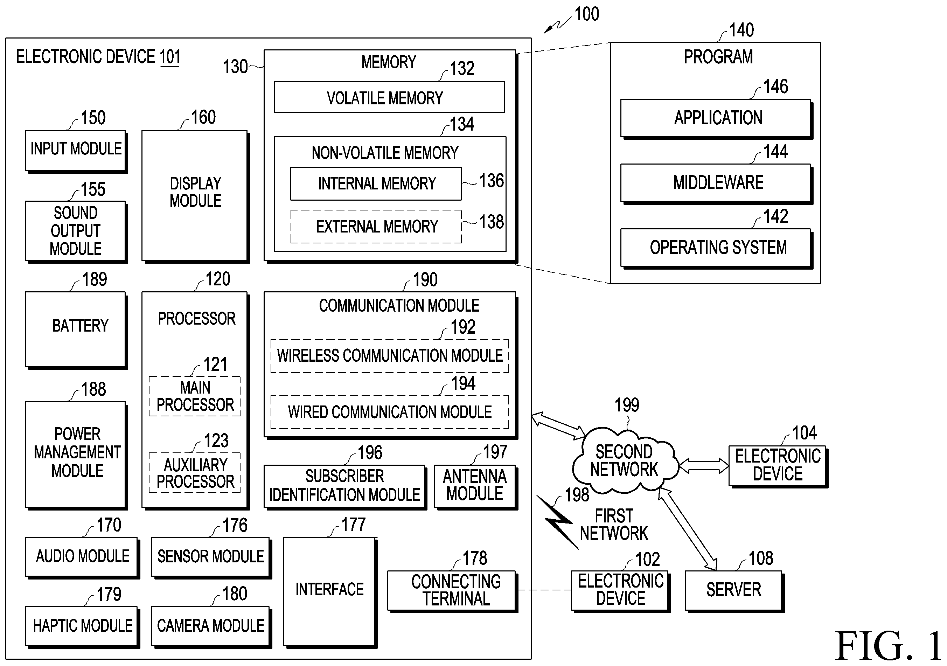

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

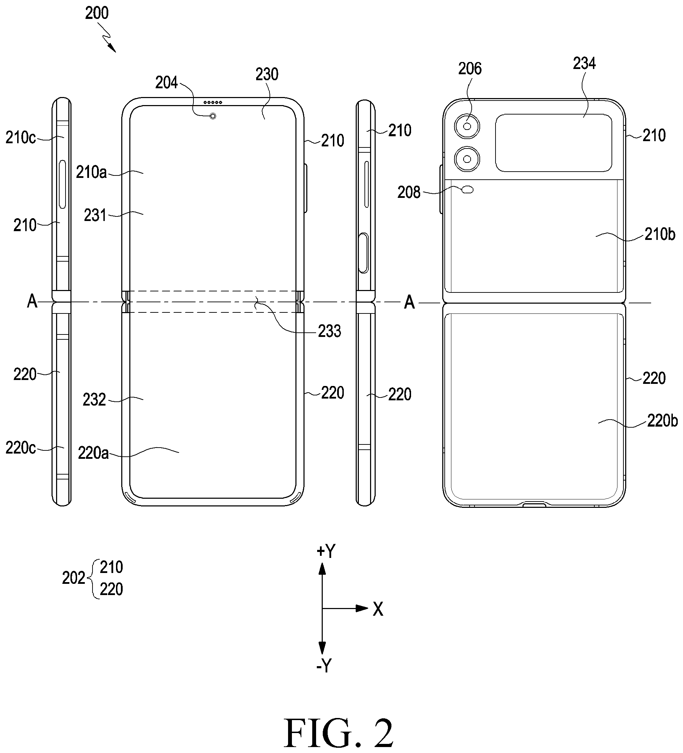

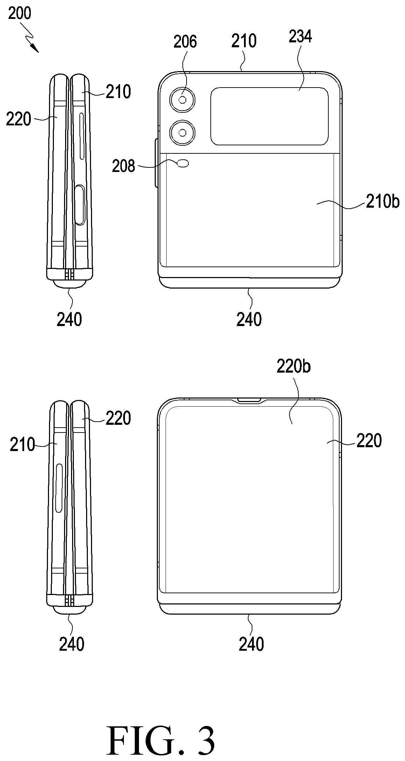

FIG. 2 is a view illustrating an electronic device according to an embodiment of the disclosure in the unfolded state. FIG. 3 is a view illustrating the electronic device according to an embodiment of the disclosure in the folded state. The configuration of the electronic device 200 of FIGS. 2 and 3 may be wholly or partly the same as that of the electronic device 101 of FIG. 1. The embodiments of FIGS. 2 and 3 may be combined with the embodiment of FIG. 1.

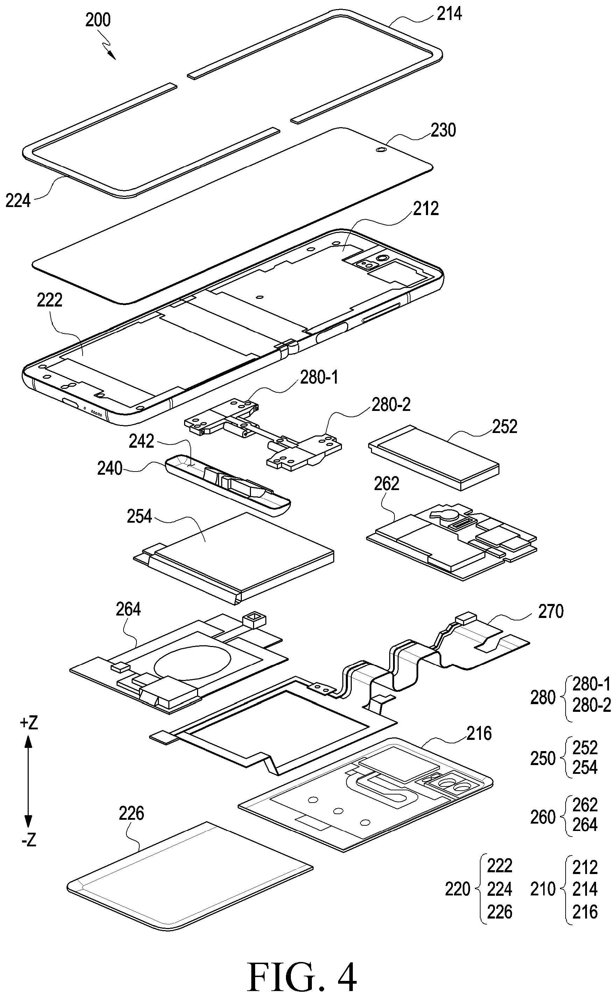

Referring to FIGS. 2 and 3, the electronic device 200 may include a housing 202 configured to accommodate components of the electronic device 200 (e.g., the hinge structure 280 in FIG. 4) and a flexible display (hereinafter, referred to as a "display 230") disposed in a space defined by the housing 202. According to an embodiment, the housing 202 may be referred to as a "foldable housing". According to an embodiment, the display 230 may be referred to as a "foldable display".

According to an embodiment, the housing 202 may include a first housing 210 and a second housing 220 configured to rotate relative to the first housing 210.

According to an embodiment, the first housing 210 and/or the second housing 220 may define at least a portion of the exterior of the electronic device 200. According to an embodiment, the surface on which the display 230 is visually exposed is defined as the front surface (e.g., a first front surface 210a and a second front surface 220a) of the electronic device 200 and/or the housing 202. The surface opposite to the front surface is defined as the rear surface (e.g., a first rear surface 210b and a second rear surface 220b) of the electronic device 200. The surface surrounding at least a portion of the space between the front and rear surfaces is defined as the side surface (e.g., a first side surface 210c and a second side surface 220c) of the electronic device 200.

According to an embodiment, the first housing 210 may be rotatably connected to the second housing 220 using a hinge structure (e.g., the hinge structure 280 in FIG. 4). For example, the first housing 210 and the second housing 220 may each be rotatably connected to the hinge structure 280. Accordingly, the electronic device 200 may change to a folded state (e.g., FIG. 3) or an unfolded state (e.g., FIG. 2). When the electronic device 200 is in the folded state, the first front surface 210a may face the second front surface 220a, and when the electronic device 200 is in the unfolded state, the direction where the first front surface 210a is oriented may be substantially the same as the direction where the second front surface 220a is oriented. For example, in the unfolded state, the first front surface 210a may be located on substantially the same plane as the second front surface 220a. According to an embodiment, the second housing 220 may move relative to the first housing 210.

According to an embodiment, the first housing 210 and the second housing 220 may be disposed on opposite sides about the folding axis A and may have generally symmetrical shapes with respect to the folding axis A. The angle between the first housing 210 and the second housing 220 may be changed depending on whether the electronic device 200 is in the unfolded state, the folded state, or an intermediate state between the unfolded state and the folded state.

According to an embodiment, the electronic device 200 may include a hinge cover 240. At least a portion of the hinge cover 240 may be disposed between the first housing 210 and the second housing 220. According to an embodiment, depending on the state of the electronic device 200, the hinge cover 240 may be covered by portions of the first housing 210 and the second housing 220 or may be exposed to the outside of the electronic device 200. According to an embodiment, the hinge cover 240 may protect the hinge structure (e.g., the hinge structure 280 in FIG. 4) from external impacts to the electronic device 200. According to an embodiment, the hinge cover 240 may be interpreted as a hinge housing to protect the hinge structure (e.g., the hinge structure 280 in FIG. 4).

According to an embodiment, as illustrated in FIG. 2, when the electronic device 200 is in the unfolded state, the hinge cover 240 may not be exposed by being covered by the first housing 210 and the second housing 220. As another example, as illustrated in FIG. 3, when the electronic device 200 is in the folded state (e.g., the fully folded state), the hinge cover 240 may be exposed to the outside between the first housing 210 and the second housing 220. As another example, when the first housing 210 and the second housing 220 are in the intermediate state in which the first and second housings are folded with a certain angle therebetween, the hinge cover 240 may be partially exposed to the outside between the first housing 210 and the second housing 220. However, in this case, the exposed region may be smaller than that in the fully folded state. In an embodiment, the hinge cover 240 may include a curved surface.

According to an embodiment, the display 230 may visually provide information to the outside of the electronic device 200 (e.g., a user). The display 230 may include, for example, a hologram device or a projector, and a control circuit to control the corresponding device. According to an embodiment, the display 230 may include a touch sensor configured to detect a touch or a pressure sensor configured to measure the intensity of force generated by the touch.

According to an embodiment, the display 230 may refer to a display, at least a portion of which is transformable into a planar surface or a curved surface. For example, the display 230 may be configured to vary in response to the relative movement of the second housing 220 with respect to the first housing 210. According to an embodiment, the display 230 may include a folding area 233, and a first display area 231 disposed on one side (e.g., above (in the +Y direction)) of the folding area 233 and a second display area 232 disposed on the other side (e.g., below (in the -Y direction)) with reference to the folding area 233. According to an embodiment, the folding area 233 may be located above the hinge structure (e.g., the hinge structure 280 in FIG. 4). For example, at least a portion of the folding area 233 may face the hinge structure 280. According to an embodiment, the first display area 231 may be disposed on the first housing 210, and the second display area 232 may be disposed on the second housing 220. According to an embodiment, the display 230 may be accommodated in the first housing 210 and the second housing 220.

However, the regional division of the display 230 illustrated in FIG. 2 is exemplary, and the display 230 may be divided into plurality of (e.g., four or more or two) areas depending on its structure or function.

In addition, in the embodiment illustrated in FIG. 2, the areas of the display 230 may be divided by the folding area 233 or the folding axis (the axis A) extending in parallel to the X-axis. However, in another embodiment, the areas of the display 230 may be divided with reference to another folding area (e.g., a folding area parallel to the Y-axis) or another folding axis (e.g., a folding axis parallel to the Y-axis). According to an embodiment, the display 230 may be coupled to or disposed adjacent to a touch detection circuit, a pressure sensor that is capable of measuring touch intensity (pressure), and/or a digitizer configured to detect a magnetic field-type stylus pen.

According to an embodiment, the electronic device 200 may include a rear display 234. The rear display 234 may be disposed to be oriented in a different direction from the display 230. For example, the display 230 may be visually exposed through the front surface (e.g., the first front surface 210a and/or the second front surface 220a) of the electronic device 200, and the rear display 234 may be visually exposed through the rear surface (e.g., the first rear surface 210b) of the electronic device 200.

According to an embodiment, the electronic device 200 may include one or more camera modules 204 and 206 and a flash 208. According to an embodiment, the electronic device 200 may include a front camera module 204 exposed through the front surface (e.g., the first front surface 210a) and/or a rear camera module 206 exposed through the rear surface (e.g., the first rear surface 220b). The camera modules 204 and 206 may include one or more lenses, image sensors, flashes, and/or image signal processors. The flash 208 may include a light-emitting diode or xenon lamp. According to an embodiment, two or more lenses (e.g., an infrared camera lens, a wide-angle lens, and a telephoto lens) and image sensors may be disposed on one surface of the electronic device 200. The configuration of the front camera module 204 and/or the rear camera module 206 may be entirely or partially identical to the configuration of the camera module 180 of FIG. 1.

FIG. 4 is an exploded perspective view of an electronic device according to an embodiment of the disclosure.

Referring to FIG. 4, the electronic device 201 may include a first housing 210, a second housing 220, a display 230, a hinge cover 240, a battery 250, a printed circuit board 260, a flexible printed circuit board 270, and a hinge structure 280. The configurations of the first housing 210, the second housing 220, the display 230, and the hinge cover 240 of FIG. 4 may be entirely or partially identical to those of the first housing 210, the second housing 210, the display 230, and the hinge cover 240 of FIG. 2 and/or FIG. 3.

According to an embodiment, the electronic device 200 may include a first support member 212 and a second support member 222. For example, the first housing 210 may include a first support member 212, and the second housing 220 may include a second support member 222. According to an embodiment, the first support member 212 and/or the second support member 222 may support components of the electronic device 200 (e.g., the display 230, the battery 250, and the printed circuit board 260).

According to an embodiment, the first support member 212 and/or the second support member 222 may be made of a metal material and/or a non-metal (e.g., polymer) material. According to an embodiment, the first support member 212 may be disposed between the display 230 and the battery 250. For example, the display 230 may be coupled to one surface of the first support member 212, and the battery 250 and the printed circuit board 260 may be disposed on the other surface.

According to an embodiment, the electronic device 200 may include a first protective member 214 and a second protective member 224. For example, the first housing 210 may include a first protective member 214, and the second housing 220 may include a second protective member 224. According to an embodiment, the protective members 214 and 224 may protect the display 230 from external impacts. For example, the first protective member 214 may at least partially surround a portion of the display 230 (e.g., the first display area 231 in FIG. 2), and the second protective member 224 may at least partially surround another portion of the display 230 (e.g., the second display area 232 of FIG. 2). According to an embodiment, the first protective member 214 may be referred to as a "first decoration member", and the second protective member 214 may be referred to as a second decoration member".

According to an embodiment, the housings 210 and 220 may include a first rear surface plate 216 and a second rear surface plate 226. For example, the first housing 210 may include the first rear surface plate 216 connected to the first support member 212, and the second housing 220 may include the second rear surface plate 216 connected to the second support member 222. According to an embodiment, the rear surface plates 216 and 226 may define a portion of the exterior of the electronic device 200. For example, the first rear surface plate 216 may define the first rear surface (e.g., the first rear surface 210b in FIGS. 2 and 3), and the second rear surface plate 226 may define the second rear surface (e.g., the second rear surface 220b in FIG. 2 to 3). According to an embodiment, a first battery 252 and a first printed circuit board 262 may be disposed between the first support member 212 and the first rear surface plate 216, and a second battery 254 and a second printed circuit board 264 may be disposed between the second support member 222 and the second rear surface plate 226.

According to an embodiment, the hinge cover 240 may accommodate at least a portion of the hinge structure 280. For example, the hinge cover 240 may include an accommodation groove 242 to accommodate the hinge structure 280. According to an embodiment, the hinge cover 240 may be coupled with the hinge structure 280. According to an embodiment, when the electronic device 200 is in the unfolded state, at least a portion of the hinge cover 240 may be located between the hinge structure 280 and the housings 210 and 220.

According to an embodiment, the battery 250 is a device to supply power to at least one component of the electronic device 200, and may include a non-rechargeable primary battery, a rechargeable secondary battery, or a fuel cell. The battery 250 may be integrally disposed inside the electronic device 200, or may be disposed to be detachable from the electronic device 200. According to an embodiment, the battery 250 may include a first battery 252 disposed in the first housing 210 and a second battery 254 disposed in the second housing 220. For example, the first battery 252 may be disposed on the first support member 212 and the second battery 254 may be disposed on the second support member 222.

According to an embodiment, a processor (e.g., the processor 220 in FIG. 1), memory (e.g., the memory 230 in FIG. 1), and/or an interface (e.g., the interface 277 in FIG. 1) may be mounted on the printed circuit board 260. According to an embodiment, the printed circuit board 260 may include a first printed circuit board 262 disposed in the first housing 210 and a second printed circuit board 264 disposed in the second housing 220.

According to an embodiment, the flexible printed circuit board (FPCB) 270 may electrically interconnect a component located in the first housing 210 (e.g., the first printed circuit board 262) and a component located in the second housing 220 (e.g., the second printed circuit board 264). According to an embodiment, at least a portion of the flexible printed circuit board 270 may cross the hinge cover 240 and/or the hinge structure 280. For example, a portion of the flexible printed circuit board 270 may be disposed within the first housing 210 and another portion may be disposed within the second housing 220. According to an embodiment, the flexible printed circuit board 270 may be connected to an antenna or may be connected to the display 230.

According to an embodiment, the hinge structure 280 may be connected to the first housing 210 and the second housing 220. According to an embodiment, the first housing 210 may rotate relative to the second housing 220 using the hinge structure 280. According to an embodiment, the hinge structure 280 may interconnect the first housing 210 and the second housing 220 to be rotatable from the folded state (e.g., FIG. 3) to the unfolded state (e.g., FIG. 2).

According to an embodiment, the hinge structure 280 may include plurality of hinge structures 280-1 and 280-2 arranged in parallel to each other. For example, the hinge structure 280 may include a first hinge structure 280-1 and a second hinge structure 280-2 spaced apart from the first hinge structure 280-1. According to an embodiment, the first hinge structure 280-1 and the second hinge structure 280-2 may be symmetrical with respect to the longitudinal direction of the electronic device 200 (e.g., the Y-axis direction).

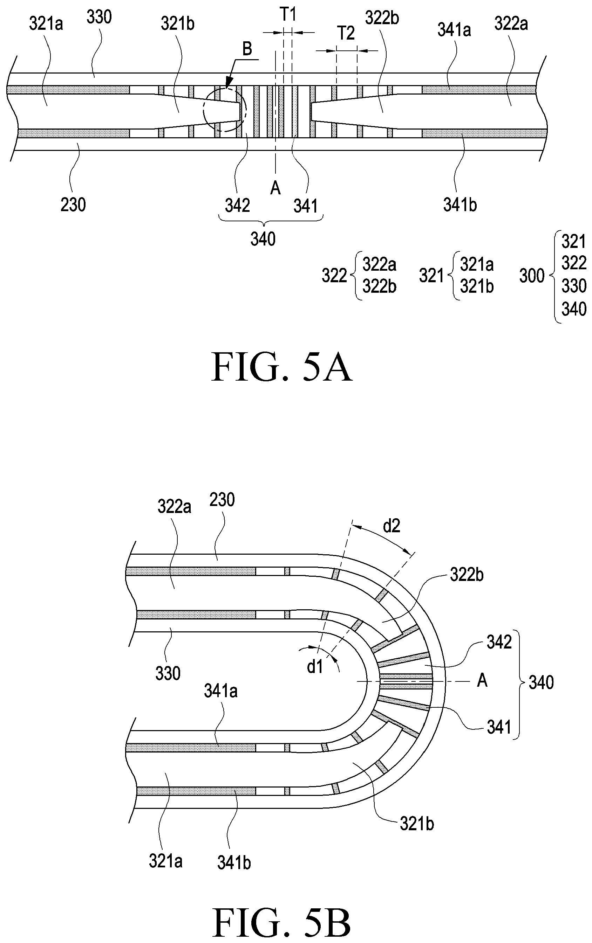

FIG. 5A is a cross-sectional view illustrating a display and a cover window according to an embodiment of the disclosure in the unfolded state. FIG. 5B is a cross-sectional view illustrating the display and the cover window according to an embodiment of the disclosure in the folded state.

Referring to FIGS. 5A and 5B, an electronic device (e.g., the electronic device 101 in FIG. 1 or the electronic device 200 in FIGS. 2 to 4) may include a display 230 and a cover window 300 laminated on one surface (or outer surface) (e.g., the surface oriented in the +Z direction in FIG. 4) of the display 230.

The configuration of the display 230 of FIGS. 5A and 5B may be entirely or partially identical to the configuration of the display 230 of FIGS. 2 to 4. The embodiments of FIGS. 5A and 5B may be combined with the embodiments of FIGS. 1 to 4.

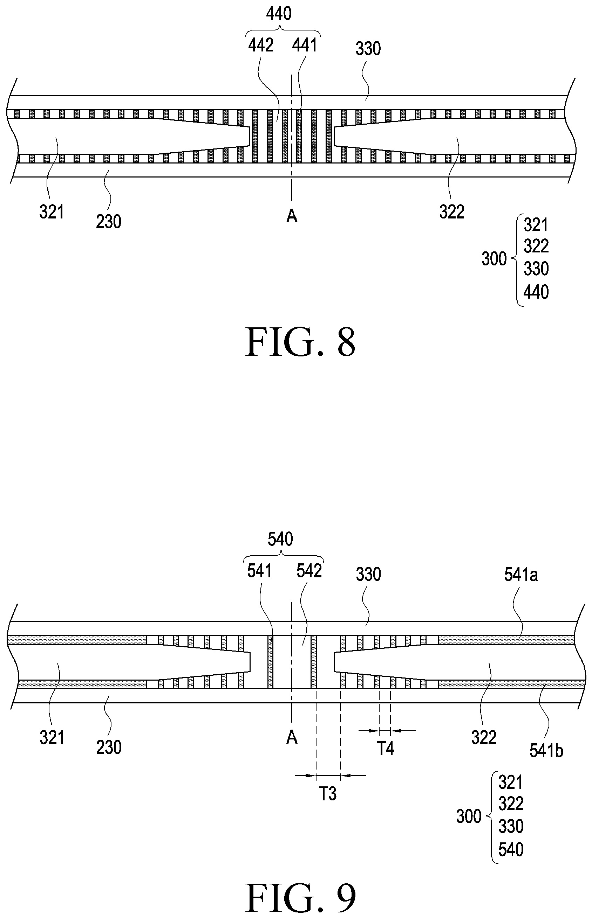

The folding axis A of the cover window 300 to be described below with reference to drawings (e.g., the folding axis A in FIGS. 5A and 5B, or the folding axis A in FIGS. 8 to 10) may be defined and interpreted as a folding axis A that is a region where the cover window 300 is folded when the electronic device (e.g., the electronic device 101 in FIG. 1 or the electronic device 200 in FIGS. 2 to 4) is in the folded state (e.g., FIG. 3 or FIG. 5B).

For example, the folding axis A of the cover window 300 (e.g., the folding axis A in FIGS. 5A and 5B, or the folding axis A in FIGS. 8 to 10) may be different from the folding axis A (e.g., the folding axis A in FIG. 2) of the housing (e.g., the electronic device 202 in FIGS. 2 and 3) described above as an example with reference to FIGS. 2 and 3. According to an embodiment, the cover window 300 may be laminated on one surface of the display 230 to protect the display 230 from external impacts. For example, the cover window 300 may be configured to cover the outer surface of the display 230.

According to an embodiment, the cover window 300 may include a first glass 321, a second glass 322, a protective layer 330, and a transparent resin layer 340.

According to an embodiment, the first glass 321 may be disposed corresponding to the first housing (e.g., the first housing 210 in FIGS. 2 to 4). According to an embodiment, the second glass 322 may be disposed corresponding to the second housing (e.g., the second housing 220 in FIGS. 2 to 4). The first glass 321 may be spaced apart from the second glass 322. For example, with reference to the folding axis A, the first glass 321 may be disposed on one side of the folding axis A, and the second glass 322 may be disposed on the other side of the folding axis A. According to an embodiment, the first glass 321 or the second glass 322 may be made of a substantially transparent and flexible member. For example, the first glass 321 or the second glass 322 may be made of a glass (e.g., ultra-thin glass (UTG)) with a thickness that allows at least one portion to be bent. According to an embodiment, the first glass 321 or the second glass 322 may be defined and referred to as thick shell glass, at least a portion of which is bendable.

According to an embodiment, the first glass 321 may be disposed between the protective layer 330 and the display 230. According to an embodiment, the first glass 321 may include a (1-1)th portion 321a and a (1-2)th portion 321b. According to an embodiment, the (1-2)th portion 321b may extend from the (1-1)th portion 321a toward the second glass 322 (or the folding axis A). According to an embodiment, the thickness (e.g., the thickness in the Z-axis direction in FIG. 4) of the (1-2)th portion 321b may be smaller than the thickness (e.g., the thickness in the Z-axis direction of FIG. 4) of the (1-1)th portion 321a. The first glass 321 may be configured such that the (1-2)th portion 321b slopes such that the thickness of the (1-2)th portion 321b gradually decreases in the direction toward the second glass 322 (or the folding axis A). According to an embodiment, the (1-1)th portion 321a may be defined and interpreted as a planar portion, and the (1-2)th portion 321b may be defined and interpreted as an inclined surface portion.

According to an embodiment, the second glass 322 may be disposed between the protective layer 330 and the display 230. According to an embodiment, the second glass 322 may include a (2-1)th portion 322a and a (2-2)th portion 322b. According to an embodiment, the (2-2)th portion 322b may extend from the (2-1)th portion 322a toward the first glass 321 (or the folding axis A). According to an embodiment, the thickness (e.g., the thickness in the Z-axis direction in FIG. 4) of the (2-2)th portion 322b may be smaller than the thickness (e.g., the thickness in the Z-axis direction of FIG. 4) of the (2-1)th portion 322a. The second glass 322 may be configured such that the (2-2)th portion 322b slopes such that the thickness of the (2-2)th portion 322b gradually decreases in the direction toward the first glass 321 (or the folding axis A). According to an embodiment, the (2-1)th portion 322a may be defined and interpreted as a planar portion, and the (2-2)th portion 322b may be defined and interpreted as an inclined surface portion.

According to an embodiment, the thickness of the protective layer 330 (e.g., the thickness in the Z-axis direction in FIG. 4) may be about 36 µm (micro-meters) to about 44 µm (micro-meters). For example, the thickness of the protective layer 330 may be about 40 µm, but may have various thickness values without being limited thereto.

According to an embodiment, the thickness of the (1-1)th portion 321a or the (2-1)th portion 322a (e.g., the thickness in the Z-axis direction in FIG. 4) may be about 54 µm (micro-meters) to about 66 µm (micro-meters). For example, the thickness of the (1-1)th portion 321a or the (2-1)th portion 322a may be about 60 µm, but may have various thickness values without being limited thereto.

According to an embodiment, the protective layer 330 may be disposed outside the first glass 321 and the second glass 322. According to an embodiment, the protective layer 330 may be an ultra-thin glass (UTG) member, a flexible thin glass (FTG) member, a protective layer (PL) film, a polyimide (PI) film, or a high hardness protective film. According to an embodiment, the protective layer 330 may be a surface of the cover window 300 that is exposed to the outside of the electronic device. According to an embodiment, at least a portion of the protective layer 330 may overlap the first glass 331 and the second glass 332 with the transparent resin layer 340 interposed therebetween in the Z-axis direction in FIG. 4.

According to an embodiment, the transparent resin layer 340 may be a resin layer filled between the protective layer 330 and the display 230. For example, the transparent resin layer 340 may be optically clear resin (OCR), but is not limited thereto.

According to an embodiment, the transparent resin layer 340 may be an optically clear adhesive (OCA). According to an embodiment, the transparent resin layer 340 may include at least one of optical grade polyurethane, silicone, acryl, polyvinyl acetate (PVAc), or epoxy resin or may include a mixture (or combination) of these materials. According to an embodiment, the transparent resin layer 340 is not limited to the elements described above and may include various optically transparent resins. According to an embodiment, the transparent resin layer 340 may be configured to bond the first glass 321 (or the second glass 322) and the protective layer 330. According to an embodiment, the transparent resin layer 340 may be configured to bond the first glass 321 (or the second glass 322) and the display 230. According to an embodiment, the refractive index or dispersion ratio of the transparent resin layer 340 may be substantially equal to the refractive index or dispersion ratio of the first glass 321 (or the second glass 322). According to an embodiment, the optical properties (e.g., refractive indices or dispersion ratios) of the transparent resin layer 340 and the first glass 321 (or the second glass 322) may be provided to be substantially identical, thereby preventing the refraction of light at the interface between the transparent resin layer 340 and the first glass 321 (or the second glass 322). **In** addition, since refraction of light is prevented at the interface between the transparent resin layer 340 and the first glass 321 (or the second glass 322), the distortion of visual images (or screen images) displayed on the display 230 may be reduced. According to an embodiment, the transparent resin layer 340 may include plurality of areas. For example, the transparent resin layer 340 may include plurality of first transparent areas 341 and plurality of second transparent areas 342.

According to an embodiment, in the unfolded state of the electronic device (e.g., FIG. 2 or FIG. 5A), the plurality of first transparent areas 341 are arranged to be spaced apart from each other in the direction from the first glass 321 toward the second glass 322, and each of the plurality of second transparent areas 342 may be disposed between adjacent ones of the plurality of first transparent areas 341. According to an embodiment, the plurality of first transparent areas 341 and the plurality of second transparent areas 342 may be defined and interpreted as being arranged by turns (or alternately). According to an embodiment, the plurality of first transparent areas 341 and the plurality of second transparent areas 342 may be defined and interpreted as forming a lattice structure (or harmonica structure).

According to an embodiment, the hardness of the plurality of first transparent areas 341 may be greater than the hardness of the plurality of second transparent areas 342. For example, the hardness of the plurality of first transparent areas 341 may be about 1.5 to 2.0 times the hardness of the plurality of second transparent areas. For example, the hardness of the plurality of first transparent areas 341 may be about 16 to 18 Shore hardness. The hardness of the plurality of second transparent areas 342 may be about 10 shore hardness. In the disclosure, Shore hardness may refer to a hardness value measured using a Shore A type indenter. For example, the hardness values presented in the disclosure may mean hardness values measured using a GS-709G hardness tester manufactured by TECLOCK Corp. According to an embodiment, the plurality of first transparent areas 341 are made of optically clear resin with relatively high hardness, and the plurality of second transparent areas 342 are made of optically clear resin with relatively low hardness.

According to an embodiment, by alternately arranging the plurality of first transparent areas 341 and the plurality of second transparent areas 342, the cover window 300 may secure folding performance or strength performance. For example, compared to a cover window including a transparent resin layer constituted only with the first transparent areas, the cover window 300 of the disclosure, which includes the second transparent areas having hardness relatively smaller than the first transparent areas, may enable a less force to be required to fold the cover window or the display on which the cover window is laminated when the electronic device is folded. **In** addition, compared to a cover window including a transparent resin layer constituted only with the second transparent areas, the cover window 300 of the disclosure, which includes the first transparent areas having relatively greater hardness than the second transparent areas, may have the improved strength against external impacts to electronic devices.

According to an embodiment, at least some 341a and 341b of the plurality of first transparent areas 341 may be disposed between the planar portion of the first glass 321 (or the second glass 322) and the protective layer 330, or may be disposed between the planar portion of the first glass 321 (or the second glass 322) and the display 230. According to an embodiment, at least some 341a and 341b of the transparent resin layer 340 may be defined or interpreted as being disposed between the planar portion of the first glass 321 (or the second glass 322) and the protective layer 330, or being disposed between the planar portion of the first glass 321 (or the second glass 322) and the display 230.

According to an embodiment, since at least some portions 341a and 341b of the transparent resin layer 340 are disposed between the planar portion of the first glass 321 (or the second glass 322) and the protective layer 330, or are disposed between the planar portion of the first glass 321 (or the second glass 322) and the display 230, the occurrence of lifting or gaps between the first glass 321 (or the second glass 322) and the transparent resin layer 340 may be prevented in the cover window 300. For example, compared to the case where the transparent resin layer is not disposed between the planar portion of the first glass (or the second glass) and the protective layer, or the case where the transparent resin layer is not disposed between the planar portion of the first glass (or the second glass) and the display, in the cover window 300 of the present disclosure. a large contact area (or bonding area) between the transparent resin layer 340 and the glasses 341 and 342 may be ensured since at least some portions 341a and 341b of the transparent resin layer 340 are also disposed between the glasses 341 and 342 and the protective layer 330 or the display 230. Accordingly, even if the electronic device is repeatedly changed from the folded state to the unfolded state, the occurrence of gaps or lifting between the transparent resin layer 340 and the glasses 341 and 342 may be prevented.

According to an embodiment, the thickness of the first transparent areas 341a and 341b disposed on the planar portion of the first glass 321 (or the second glass 322) among the plurality of first transparent areas 341 (e.g., the thickness in the Y-axis direction in FIG. 2) may be greater than the thickness of the remaining first transparent areas 341. The thicknesses of the remaining first transparent areas 341 may be substantially the same.

According to an embodiment, with reference to the folding axis A, the plurality of first transparent areas 341 may be arranged such that the intervals between the plurality of first transparent areas 341 gradually increase in the direction toward the first glass 321 (or the second glass 322). According to an embodiment, the intervals between the plurality of first transparent areas 341 may gradually increase in the direction away from the folding axis A. According to an embodiment, the thicknesses (or widths) of the intervals between the plurality of first transparent areas 341 may be defined or interpreted as the thicknesses (or widths) of the plurality of second transparent areas 342 disposed between the plurality of first transparent areas 341. According to an embodiment, the plurality of first transparent areas 341 are not limited to being arranged such that the intervals gradually increase, but may be arranged at different intervals or at equal intervals. For example, a first interval, which is one of the intervals of the plurality of first transparent areas 341, may have a different thickness (or length) from a second interval adjacent to the first interval, or may have substantially the same thickness as the second interval. In addition, the second interval may be larger than the first interval, and a third interval (an interval other than the first interval) adjacent to the second interval may be smaller than the second interval. In addition, the plurality of first transparent areas 341 may be arranged such that various intervals are alternately disposed.

According to an embodiment, an interval T1 between a pair of first transparent areas 341 relatively adjacent to the folding axis A may be smaller than an interval T2 between a pair of transparent areas 341 disposed relatively far from the folding axis A. According to an embodiment, the maximum interval among the intervals between the plurality of first transparent areas 341 may be about 1.0 mm or less. According to an embodiment, the minimum interval among the intervals between the plurality of first transparent areas 341 may be about 0.3 mm or less.

According to an embodiment, when the electronic device is in the folded state (e.g., FIG. 3 or FIG. 5B), the second transparent areas 342 disposed at positions corresponding to the folding area (e.g., the folding area 233 in FIG. 2) may be configured such that at least some of the second transparent areas contract and the remainders stretch. For example, among the second transparent areas 342 disposed at positions corresponding to the folding area, the second transparent areas 342 disposed between the first glass 321 (or the second glass 322) and the protective layer 330 may contract to have a first thickness d1. For example, among the second transparent areas 342 disposed at positions corresponding to the folding area, the second transparent areas 342 disposed between the first glass 321 (or the second glass 322) and the display 230 may stretch to have a second thickness d2. For example, the first thickness d1 may be smaller than the thickness of the corresponding second transparent areas 342 when the electronic device is in the unfolded state. For example, the second thickness d2 may be larger than the thickness of the corresponding second transparent areas 342 when the electronic device is in the unfolded state.

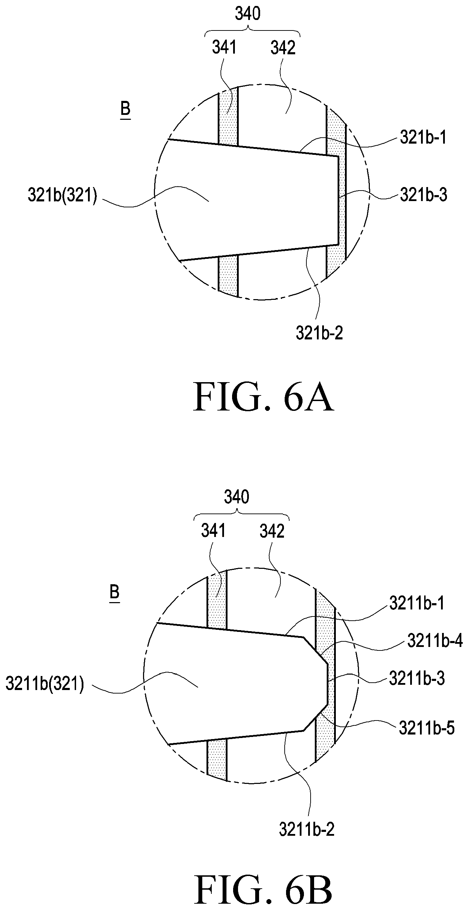

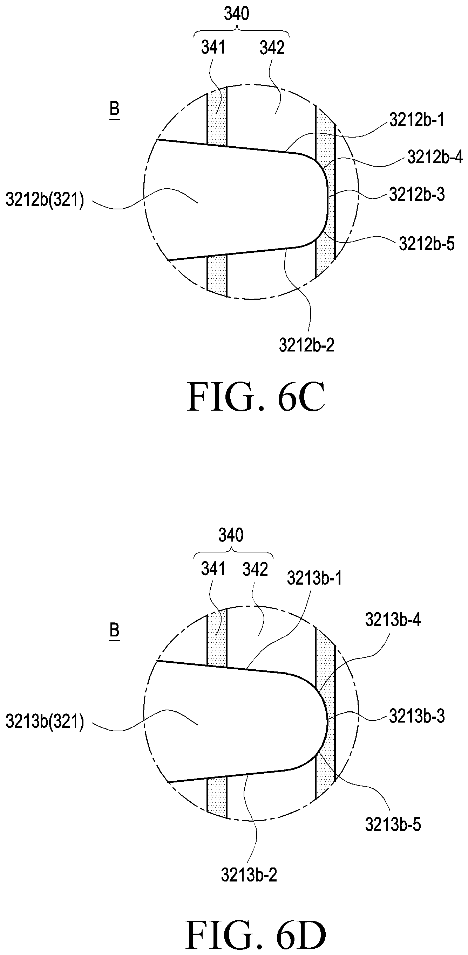

FIG. 6A is an enlarged view of the portion "B" of FIG. 5A, according to an embodiment of the disclosure. FIG. 6B is an enlarged view of the portion "B" of FIG. 5A, according to an embodiment of the disclosure. FIG. 6C is an enlarged view of the portion "B" of FIG. 5A, according to an embodiment of the disclosure. FIG. 6D is an enlarged view of the portion "B" of FIG. 5A, according to an embodiment of the disclosure.

The embodiments of FIGS. 6A to 6B may be combined with the embodiments of FIGS. 1 to 5B.

Referring to FIGS. 6A to 6D, the cover window (e.g., the cover window 300 in FIGS. 5A and 5B) may include a transparent resin layer 340 having plurality of first transparent areas 341 and plurality of second transparent areas 342, and a first glass 321.

The configurations of the plurality of first transparent areas 341, the plurality of second transparent areas 342, the transparent resin layer 340, and the first glass 321 of FIGS. 6A to 6D may be entirely or partially identical to those of the plurality of first transparent areas 341, the plurality of second transparent areas 342, the transparent resin layer 340, and the first glass 321 of FIGS. 5A and 5B.

Referring to FIGS. 6A to 6D, the first glass 321 may include (1-2)th portions 321b, 3211b, 3212b, and 3213b. The configuration of the (1-2)th portions 321b, 3211b, 3212b, and 3213b of FIGS. 6A to 6D may be entirely or partially identical to that of the (1-2)th portion 321b of FIGS. 5A and 5B.

Hereinafter, the (1-2)th portions 321b, 3211b, 3212b, and 3213b of the first glass 321 will be described with reference to FIGS. 6A to 6D as an example, but this description may be similarly or identically applicable to the (2-2)th portion (e.g., the (2-2)th portion 322b in FIGS. 5A and 5B)) of the second glass (e.g., the second glass 322 in FIGS. 5A and 5B).

Referring to FIG. 6A, the (1-2)th portion 321b may include a first inclined surface 321b-1 facing the protective layer (e.g., the protective layer 330 in FIGS. 5A and 5B), a second inclined surface 321b-2 facing the display (e.g., the display 230 in FIGS. 5A and 5B), and a first connection surface 321b-3 facing the second glass (e.g., the second glass 322 in FIGS. 5A and 5B).

According to an embodiment, the first connection surface 321b-3 may interconnect one end of the first inclined surface 321b-1 (e.g., the end facing the second glass) and one end of the second inclined surface 321b-2 (e.g., the end facing the second glass). According to an embodiment, the first connection surface 321b-3 may be a flat surface.

Referring to FIG. 6B, the (1-2)th portion 3211b may include a first inclined surface 3211b-1 facing the protective layer (e.g., the protective layer 330 in FIGS. 5A and 5B), a second inclined surface 3211b-2 facing the display (e.g., the display 230 in FIGS. 5A and 5B), a first connection surface 3211b-3 facing the second glass (e.g., the second glass 322 in FIGS. 5A and 5B), a first chamfer surface 3211b-4, and a second chamfer surface 3211b-5.

According to an embodiment, the first chamfer surface 3211b-4 may be a flat surface obtained by chamfering the corner between the first inclined surface 3211b-1 and the first connection surface 3211b-3. According to an embodiment, the second chamfer surface 3211b-5 may be a flat surface obtained by cutting the corner between the second inclined surface 3211b-2 and the first connection surface 3211b-3. According to an embodiment, the first connection surface 3211b-3 may be a flat surface.

Referring to FIG. 6C, the (1-2)th portion 3212b may include a first inclined surface 3212b-1 facing the protective layer (e.g., the protective layer 330 in FIGS. 5A and 5B), a second inclined surface 3212b-2 facing the display (e.g., the display 230 in FIGS. 5A and 5B), a first connection surface 3212b-3 facing the second glass (e.g., the second glass 322 in FIGS. 5A and 5B), a first curved surface 3212b-4, and a second curved surface 3212b-5.

According to an embodiment, the first curved surface 3212b-4 may be a curved surface obtained by cutting the corner between the first inclined surface 3212b-1 and the first connection surface 3212b-3. According to an embodiment, the second curved surface 3212b-5 may be a curved surface obtained by cutting the corner between the second inclined surface 3212b-2 and the first connection surface 3212b-3. According to an embodiment, the first connection surface 3212b-3 may be a flat surface.

According to an embodiment, the radius of curvature of the first curved surface 3212b-4 or the radius of curvature of the second curved surface 3212b-5 may be about 1.0 µm (micro-meters) or more, but is not limited thereto.

Referring to FIG. 6D, the (1-2)th portion 3213b may include a first inclined surface 3213b-1 facing the protective layer (e.g., the protective layer 330 in FIGS. 5A and 5B), a second inclined surface 3213b-2 facing the display (e.g., the display 230 in FIGS. 5A and 5B), a first connection surface 3213b-3 facing the second glass (e.g., the second glass 322 in FIGS. 5A and 5B), a first curved surface 3213b-4, and a second curved surface 3213b-5.

According to an embodiment, the first curved surface 3213b-4 may be a curved surface obtained by cutting the corner between the first inclined surface 3213b-1 and the first connection surface 3213b-3. According to an embodiment, the second curved surface 3213b-5 may be a curved surface obtained by cutting the corner between the second inclined surface 3213b-2 and the first connection surface 3213b-3. According to an embodiment, the first connection surface 3213b-3 may be formed as a curved surface. According to an embodiment, the first curved surface 3213b-4, the first connection surface 3213b-3, and the second curved surface 3213b-5 may be substantially defined and interpreted as one curved surface.

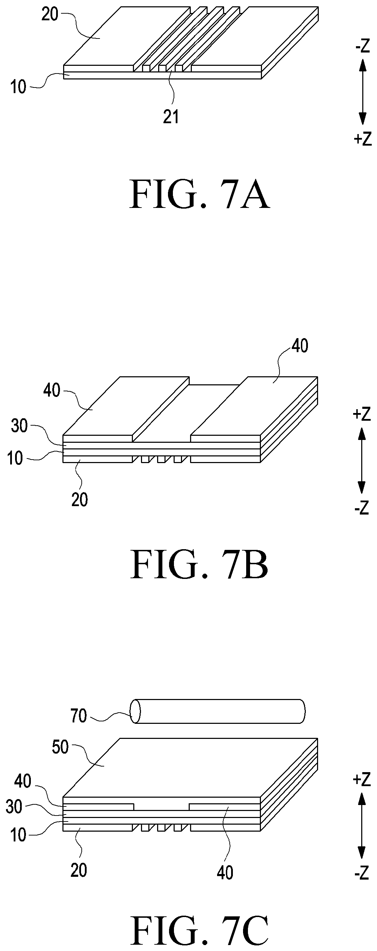

FIGS. 7A to 7E are views illustrating a process of manufacturing a cover window according to an embodiment of the disclosure.

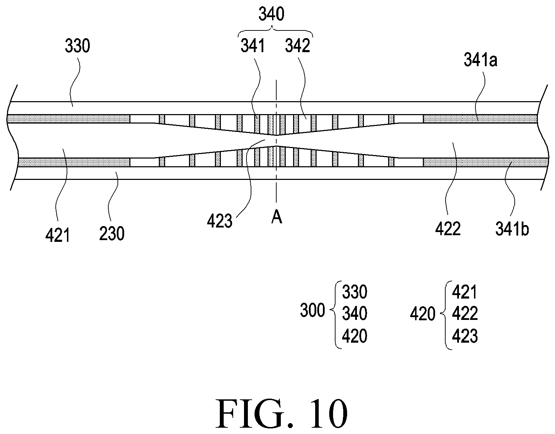

The process of manufacturing a cover window to be described with reference to FIGS. 7A to 7E may be applied to a process of manufacturing the cover window of FIGS. 5A and 5B, the cover window of FIG. 8, the cover window of FIG. 9, or the cover window of FIG. 10.

The process of manufacturing the cover window of FIGS. 7A to 7E may be performed in the order described below, but is not limited thereto.

Referring to FIG. 7A, a masking 20 (or masking tape) may be coated or printed on one surface (e.g., the surface oriented in the -Z direction in FIG. 7A) of the protective layer 10 (e.g., the protective layer 330 in FIGS. 5A and 5B). According to an embodiment, the masking coating 20 may include one or more slits 21.

Referring to FIG. 7B, at least one glass 40 (e.g., the first glass 321 or the second glass 322 in FIGS. 5A and 5B) may be bonded to the other surface (e.g., the surface oriented in the +Z direction in FIG. 7B) of the protective layer 10 in the state of being coated with the masking 20 via an optically clear adhesive 30 (OCA).

Referring to FIG. 7C, the optically clear resin (OCR) 50 may be applied to the glass 40 and the OCA 30, and ultraviolet rays (UV) are emitted to the applied OCR 50 via a UV emitter 70 to primarily cure the OCR 50. According to an embodiment, in the primary UV curing process, the OCA 30 or the OCR 50 may form plurality of second transparent areas having first hardness (e.g., the second transparent areas 342 in FIGS. 5A and 5B).

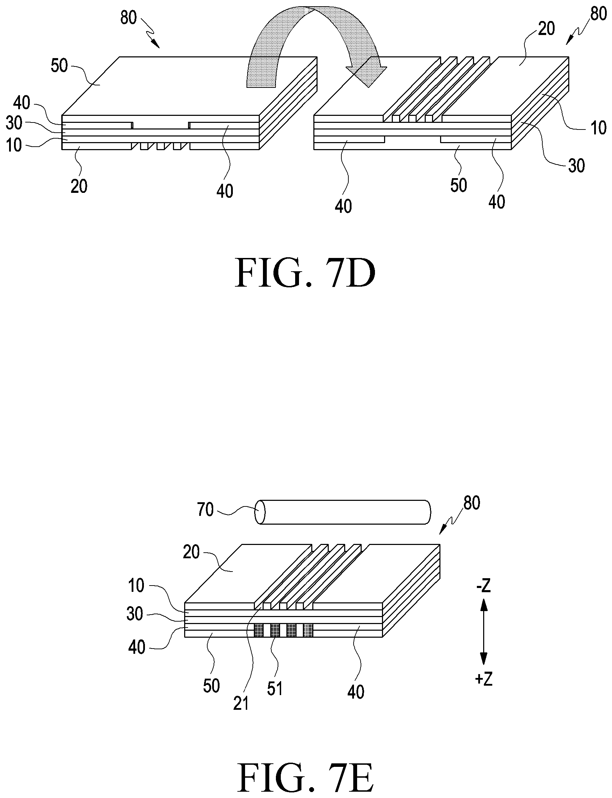

Referring to FIGS. 7D and 7E, a laminate 80 of the above-described components may be turned over, UV may be emitted toward the masking 20 via the UV emitter 70 to secondarily cure the applied OCR 50. According to an embodiment, in the secondary UV curing process, the portions of the OCR 50 corresponding to the slits 21 of the masking 20 are secondarily cured by the UV reaching the masking 20, but portions that do not correspond to the slits 21 of the masking 20 cannot be secondarily cured because UV do not reach the portions. According to an embodiment, the secondarily cured OCA 30 or OCR 50 may form plurality of first transparent areas 51 (e.g., the first transparent areas 341 in FIGS. 5A and 5B) having second hardness higher than the first hardness. According to an embodiment, the portions of the OCA 30 or the OCR 50 that is not secondarily cured may form plurality of second transparent areas (e.g., the first transparent areas 342 in FIGS. 5A and 5B) having first hardness smaller than the second hardness of the plurality of first transparent areas 51. The secondary curing process may be performed once or may be performed repeatedly two or more times.

According to an embodiment, the laminate on which the secondary curing process has been completed may form a cover window. According to an embodiment, the cover window may be additionally subjected to a laser cutting process to trim the outer edges (perimeter).

FIG. 8 is a cross-sectional view illustrating a display and a cover window according to an embodiment of the disclosure in the unfolded state.

Referring to FIG. 8, an electronic device (e.g., the electronic device 101 in FIG. 1 or the electronic device 200 in FIGS. 2 to 4) may include a display 230 and a cover window 300 laminated on one surface of the display 230.

The configurations of the display 230 and the cover window 300 of FIG. 8 may be entirely or partially the same as those of the display 230 and the cover window 300 in FIGS. 5A and 5B. The embodiment of FIG. 8 may be combined with the embodiments of FIGS. 1 to 7E.

According to an embodiment, the cover window 300 may include a first glass 321 member (e.g., the first glass 321 in FIGS. 5A and 5B), a second glass 322 (e.g., the second glass 322 in FIGS. 5A and 5B), a protective layer 330 (e.g., the protective layer 330 in FIGS. 5A and 5B), and a transparent resin layer 440 (e.g., the transparent resin layer 340 in FIGS. 5A and 5B).

According to an embodiment, the transparent resin layer 440 may be a resin layer filled between the protective layer 330 and the display 230. For example, the transparent resin layer 440 may be optically clear resin (OCR), but is not limited thereto. According to an embodiment, the transparent resin layer 440 may be an optically clear adhesive (OCA). According to an embodiment, the transparent resin layer 440 may be configured to bond the first glass 321 (or the second glass 322) and the protective layer 330. According to an embodiment, the transparent resin layer 440 may be configured to bond the first glass 321 (or the second glass 322) and the display 230.

According to an embodiment, the transparent resin layer 440 may include plurality of areas. For example, the transparent resin layer 440 may include plurality of first transparent areas 441 (e.g., the first transparent areas 341 in FIGS. 5A and 5B) and plurality of second transparent areas 442 (e.g., the second transparent areas 342 in FIGS. 5A and 5B).

According to an embodiment, in the unfolded state of the electronic device (e.g., FIG. 2 or FIG. 8), the plurality of first transparent areas 441 are arranged to be spaced apart from each other in the direction from the first glass 421 toward the second glass 422, and each of the plurality of second transparent areas 442 may be disposed between adjacent ones of the plurality of first transparent areas 441. According to an embodiment, the plurality of first transparent areas 441 and the plurality of second transparent areas 442 may be defined and interpreted as being arranged by turns (or alternately). According to an embodiment, the plurality of first transparent areas 441 and the plurality of second transparent areas 442 may be defined and interpreted as forming a lattice structure (or harmonica structure).

According to an embodiment, the hardness of the plurality of first transparent areas 441 may be greater than the hardness of the plurality of second transparent areas 442. For example, the hardness of the plurality of first transparent areas 441 may be about 1.5 to 2.0 times the hardness of the plurality of second transparent areas.

According to an embodiment, with reference to the folding axis A, the plurality of first transparent areas 441 may be arranged at equal intervals in the direction toward the first glass 421 (or the second glass 422). According to an embodiment, the thicknesses (or widths) of the intervals between the plurality of first transparent areas 441 may be defined or interpreted as the thicknesses (or widths) of the plurality of second transparent areas 442 disposed between the plurality of first transparent areas 441. According to an embodiment, the plurality of first transparent areas 441 are not limited to being arranged at equal intervals, but may be arranged at different intervals. For example, a first interval, which is one of the intervals of the plurality of first transparent areas 441, may have a different thickness (or length) from a second interval adjacent to the first interval. In addition, the plurality of first transparent areas 441 may be arranged such that various intervals are alternately disposed.

FIG. 9 is a cross-sectional view illustrating the unfolded state of a display and a cover window according to an embodiment of the disclosure.

Referring to FIG. 9, an electronic device (e.g., the electronic device 101 in FIG. 1 or the electronic device 200 in FIGS. 2 to 4) may include a display 230 and a cover window 300 laminated on one surface of the display 230.

The configurations of the display 230 and the cover window 300 of FIG. 9 may be entirely or partially the same as those of the display 230 and the cover window 300 in FIGS. 5A and 5B. The embodiment of FIG. 9 may be combined with the embodiments of FIGS. 1 to 8.

According to an embodiment, the cover window 300 may include a first glass 321 (e.g., the first glass 321 in FIGS. 5A and 5B), a second glass 322 (e.g., the second glass 322 in FIGS. 5A and 5B), a protective layer 330 (e.g., the protective layer 330 in FIGS. 5A and 5B), and a transparent resin layer 540 (e.g., the transparent resin layer 340 in FIGS. 5A and 5B).

According to an embodiment, the transparent resin layer 540 (e.g., the transparent resin layer 340 in FIGS. 5A and 5B) may be a resin layer filled between the protective layer 330 and the display 230. For example, the transparent resin layer 540 may be optically clear resin (OCR), but is not limited thereto. According to an embodiment, the transparent resin layer 540 may be an optically clear adhesive (OCA). According to an embodiment, the transparent resin layer 540 may be configured to bond the first glass 321 (or the second glass 322) and the protective layer 330. According to an embodiment, the transparent resin layer 540 may be configured to bond the first glass 321 (or the second glass 322) and the display 230.

According to an embodiment, the transparent resin layer 540 may include plurality of areas. For example, the transparent resin layer 540 may include plurality of first transparent areas 541 (e.g., the first transparent areas 341 in FIGS. 5A and 5B) and plurality of second transparent areas 542 (e.g., the second transparent areas 342 in FIGS. 5A and 5B).

According to an embodiment, in the unfolded state of the electronic device (e.g., FIG. 2 or FIG. 9), the plurality of first transparent areas 541 are arranged to be spaced apart from each other in the direction from the first glass 321 toward the second glass 322, and each of the plurality of second transparent areas 542 may be disposed between adjacent ones of the plurality of first transparent areas 541. According to an embodiment, the plurality of first transparent areas 541 and the plurality of second transparent areas 542 may be defined and interpreted as being arranged by turns (or alternately). According to an embodiment, the plurality of first transparent areas 541 and the plurality of second transparent areas 542 may be defined and interpreted as forming a lattice structure (or harmonica structure).

According to an embodiment, the hardness of the plurality of first transparent areas 541 may be greater than the hardness of the plurality of second transparent areas 542. For example, the hardness of the plurality of first transparent areas 541 may be about 1.5 to 2.0 times the hardness of the plurality of second transparent areas.

According to an embodiment, at least some 541a and 541b of the plurality of first transparent areas 541 may be disposed between the planar portion of the first glass 321 (or the second glass 322) and the protective layer 330, or may be disposed between the planar portion of the first glass 321 (or the second glass 322) and the display 230.

According to an embodiment, the thickness of the first transparent areas 541a and 541b disposed on the planar portion of the first glass 321 (or the second glass 322) among the plurality of first transparent areas 541 (e.g., the thickness in the Y-axis direction in FIG. 2) may be greater than the thickness of the remaining first transparent areas 541. The thicknesses of the remaining first transparent areas 541 may be substantially the same.

According to an embodiment, with reference to the folding axis A, the plurality of first transparent areas 541 may be arranged such that the intervals between the plurality of first transparent areas 541 gradually decreases in the direction toward the first glass 321 (or the second glass 322). According to an embodiment, the intervals between the plurality of first transparent areas 541 may gradually decrease in the direction away from the folding axis A. According to an embodiment, the thicknesses (or widths) of the intervals between the plurality of first transparent areas 541 may be defined or interpreted as the thicknesses (or widths) of the plurality of transparent areas 542 disposed between the plurality of first transparent areas 541. According to an embodiment, the plurality of first transparent areas 541 are not limited to being arranged such that the intervals gradually decrease, but may be arranged at different intervals or at equal intervals. For example, a first interval, which is one of the intervals of the plurality of first transparent areas 541, may have a different thickness (or length) from a second interval adjacent to the first interval, or may have substantially the same thickness as the second interval. For example, the second interval may be smaller than the first interval, and a third interval (an interval other than the first interval) adjacent to the second interval may be larger than the second interval. In addition, the plurality of first transparent areas 541 may be arranged such that various intervals are alternately disposed.

According to an embodiment, an interval T3 between a pair of first transparent areas 541 relatively adjacent to the folding axis A may be larger than an interval T4 between a pair of first transparent areas 541 disposed relatively far from the folding axis A. According to an embodiment, the maximum interval among the intervals between the plurality of first transparent areas 541 may be about 1.0 mm or less. According to an embodiment, the minimum interval among the intervals between the plurality of first transparent areas 541 may be about 0.3 mm or less.

FIG. 10 is a cross-sectional view illustrating the unfolded state of a display and a cover window according to an embodiment of the disclosure.

Referring to FIG. 10, an electronic device (e.g., the electronic device 101 in FIG. 1 or the electronic device 200 in FIGS. 2 to 4) may include a display 230 and a cover window 300 laminated on one surface of the display 230.

The configurations of the display 230 and the cover window 300 of FIG. 10 may be entirely or partially the same as those of the display 230 and the cover window 300 in FIGS. 5A and 5B. The embodiment of FIG. 10 may be combined with the embodiments of FIGS. 1 to 9.

According to an embodiment, the cover window 300 may include a glass 420, a protective layer 330 (e.g., the protective layer 330 in FIGS. 5A and 5B), and a transparent resin layer 340 (e.g., the transparent resin layer 340 in FIGS. 5A and 5B).

According to an embodiment, the glass 420 may include a first glass 421, a second glass 422, and a folding glass 423. According to an embodiment, the first glass 421 (e.g., the first glass 321 in FIGS. 5A and 5B) may be disposed in the first housing (e.g., the first housing 210 in FIGS. 2 to 4). According to an embodiment, the second glass 422 (e.g., the second glass 422 in FIGS. 5A and 5B) may be disposed in the second housing (e.g., the second housing 220 in FIGS. 2 to 4).

According to an embodiment, the folding glass 423 may be disposed at a position corresponding to the folding area (e.g., the folding area 233 in FIG. 2) when the electronic device is in the folded state (e.g., FIG. 3 or FIG. 5B) or in the unfolded state (e.g., FIG. 2 or FIG. 5A).

According to an embodiment, the folding glass 423 may be a portion interconnecting the first glass 421 and the second glass 422. According to an embodiment, the first glass 421 may be defined and interpreted as being connected to the second glass 422. According to an embodiment, the glass 420 may be formed as a single piece.

According to an embodiment, the protective layer 330 (e.g., the protective layer 330 in FIGS. 5A and 5B) may be disposed outside the glass 420. According to an embodiment, the transparent resin layer 340 (e.g., the transparent resin layer 340 in FIGS. 5A and 5B) may be a resin layer filled between the protective layer 330 and the glass 420 or between the glass 420 and the display 230. According to an embodiment, the transparent resin layer 340 may include plurality of first transparent areas 341 (e.g., the first transparent areas 341 in FIGS. 5A and 5B) and plurality of second transparent areas 342 (e.g., the second transparent areas 342 in FIGS. 5A and 5B).

According to an embodiment, the cover window 300 illustrated in FIGS. 5A and 5B and FIGS. 8 to 10 has been described as an example of an in-folding type electronic device where the protective layer 330 is positioned on the inner side of the electronic device when the electronic device or the display is in the folded state. However, the cover window is not limited to this and may be equally applicable to an out-folding type electronic device where the protective layer 330 is positioned on the outer side of the electronic device when the electronic device or the display is in the folded state.

An electronic device (e.g., a portable terminal) may include a display having a flat surface or a flat surface and a curved surface. An electronic device including a display may have a limitation in implementing a screen larger than the size of the electronic device due to a fixed display structure. Accordingly, electronic devices including flexible displays (or foldable displays) are being researched.

An electronic device including a foldable display may include a cover window to protect the display from external impacts. When the thickness of the cover window increases, the strength performance of the display and the cover window improves, but folding performance may deteriorate. In addition, when the thickness of the cover window is reduced, the folding performance of the display and the cover window is improved, but the strength performance may deteriorate.

According to an embodiment of the disclosure, a cover window that protects a display and reduces a force required to fold the display and an electronic device including the cover window may be provided.

However, the problems to be solved in the disclosure are not limited to the above-mentioned problems, and may be variously expanded without departing from the scope of the disclosure.

According to an embodiment of the disclosure, a cover window that is capable of reducing the occurrence of lifting between a glass and a transparent resin layer and an electronic device including the same may be provided.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device (e.g., the electronic device 101 in FIG. 1 or the electronic device 200 in FIGS. 2 to 4) may include a housing (e.g., the housing 202 in FIGS. 2 and 3), a hinge structure (e.g., the hinge structure 280 in FIG. 4), a flexible display (e.g., the display 230 in FIGS. 2 to 4), and a cover window (e.g., the cover window 300 in FIGS. 5A and 5B or the cover window 300 in FIGS. 8 to 10). The housing may include a first housing (e.g., the first housing 210 in FIGS. 2 to 4) and a second housing (e.g., the second housing 220 in FIGS. 2 to 4). The second housing may be configured to provide a relative movement with respect to the first housing. The hinge structure may connect the first housing and the second housing to be rotatable from a folded state to an unfolded state. The flexible display may be configured to vary in response to the relative movement of the first housing with respect to the second housing. The cover window may be configured to cover the outer surface of the flexible display. The cover window may include a first glass (e.g., the first glass 321 in FIGS. 5A and 5B, the first glass 321 in FIGS. 8 and 9, or the first glass 421 in FIG. 10), a second glass (e.g., the second glass 322 in FIGS. 5A and 5B, the second glass 322 in FIGS. 8 and 9, or the second glass 422 in FIG. 10), a protective layer (e.g., the protective layer 330 in FIGS. 5A and 5B or the protective layer 330 in FIGS. 8 to 10), and a transparent resin layer (e.g., the transparent resin layer 340 in FIGS. 5A and 5B, the transparent resin layer 440 in FIG. 8, the transparent resin layer 540 in FIG. 9, or the transparent resin layer 330 in FIG. 10). The first glass may be disposed corresponding to the first housing. The second glass may be disposed corresponding to the second housing. The protective layer may be disposed outside the first glass and the second glass. The transparent resin layer may be filled between the protective layer and the flexible display. The transparent resin layer may include plurality of first transparent areas (e.g., the first transparent areas 341 in FIGS. 5A and 5B, the first transparent areas 441 in FIG. 8, the first transparent areas 541 in FIG. 9, or the first transparent areas 341 in FIG. 10), and plurality of second transparent areas (e.g., the second transparent areas 342 in FIGS. 5A and 5B, the second transparent areas 442 in FIG. 8, the second transparent areas 542 in FIG. 9, or the second transparent areas 342 in FIG. 10). The plurality of first transparent areas may be spaced apart from each other in a direction from the first glass toward the second glass. The plurality of second transparent areas may be disposed between the plurality of first transparent areas. The hardness of the plurality of first transparent areas may be greater than hardness of the plurality of second transparent areas.

With reference to the folding axis (e.g., the folding axis A in FIGS. 5A and 5B, or the folding axis A in FIG. 10) of the cover window, the intervals between the plurality of first transparent areas (e.g., the first transparent areas 341 in FIGS. 5A and 5B or the first transparent areas 341 in FIG. 10) may gradually increase in a direction away from the folding axis.

The maximum interval among the intervals between the plurality of first transparent areas may be 1.0 mm or less.

The first glass (e.g., the first glass 341 in FIGS. 5A and 5B or the first glass 341 in FIGS. 8 and 9) and the second glass (e.g., the second glass 342 in FIGS. 5A and 5B or the second glass 342 in FIGS. 8 and 9) may be spaced apart from each other.

The first glass (e.g., the first glass 441 in FIG. 10) and the second glass (e.g., the second glass 442 in FIG. 10) may be integrally formed.

With respect to the folding axis (e.g., the folding axis A in FIG. 8) of the cover window, the intervals between the plurality of first transparent areas (e.g., the first transparent areas 441 in FIG. 8) may be arranged at equal intervals.

With respect to the folding axis (e.g., the folding axis A in FIG. 9) of the cover window, the intervals between the plurality of first transparent areas (e.g., the first transparent areas 541 in FIG. 9) may gradually decrease in the direction away from the folding axis.

One of the plurality of second transparent areas may be disposed on the folding axis of the cover window.

The flexible display may include a first display area (e.g., the first display area 231 in FIGS. 2 and 3), a second display area (e.g., the second display area 232 in FIGS. 2 and 3), and a folding area (e.g., the folding area 233 in FIGS. 2 and 3). The first display area may be disposed on the first housing. The second display area may be disposed on the second housing. The folding area may interconnect the first display area and the second display area.

When the housing is in the folded state, at least some of the second transparent areas (e.g., the second transparent areas 342 in FIG. 5B) disposed corresponding to the folding area may be configured to contract, while the remaining ones may be configured to stretch.

The hardness of the plurality of first transparent areas may be 1.5 to 2.0 times the hardness of the plurality of second transparent areas.

The transparent resin layer may include an optical clear resin.

In the first glass, the portion facing the second glass (e.g., the (1-2)th portion 321b in FIGS. 5A and 5B) may have a smaller thickness than another portion (e.g., the (1-1)th portion 321a in FIGS. 5A and 5B). In the second glass, the portion facing the first glass (e.g., the (2-2)th portion 322b in FIGS. 5A and 5B) may have a smaller thickness than another portion (e.g., the (2-1)th portion 322a in FIGS. 5A and 5B).

The protective layer may be a flexible thin glass.

The transparent resin layer may be configured to bond at least one of the first glass or the second glass to the protective layer and the display. The transparent resin layer may be configured to bond the first glass to the protective layer and the display. The transparent resin layer may be configured to bond the second glass to the protective layer and the display.

According to an embodiment of the disclosure, an electronic device (e.g., the electronic device 101 in FIG. 1 or the electronic device 200 in FIGS. 2 to 4) may include a housing (e.g., the housing 202 in FIGS. 2 and 3), a hinge structure (e.g., the hinge structure 280 in FIG. 4), a flexible display (e.g., the display 230 in FIGS. 2 to 4), and a cover window (e.g., the cover window 300 in FIGS. 5A and 5B or the cover window 300 in FIGS. 8 to 10). The housing may include a first housing (e.g., the first housing 210 in FIGS. 2 to 4) and a second housing (e.g., the second housing 220 in FIGS. 2 to 4). The second housing may be configured to move relative to the first housing. The hinge structure may interconnect the first housing and the second housing to be rotatable from a folded state to an unfolded state. The flexible display may be configured to vary in response to the relative movement of the first housing with respect to the second housing. The cover window may be configured to cover the outer surface of the flexible display. The cover window may include a first glass (e.g., the first glass 321 in FIGS. 5A and 5B, the first glass 321 in FIGS. 8 and 9, or the first glass 421 in FIG. 10), a second glass (e.g., the second glass 322 in FIGS. 5A and 5B, the second glass 322 in FIGS. 8 and 9, or the second glass 422 in FIG. 10), a protective layer (e.g., the protective layer 330 in FIGS. 5A and 5B or the protective layer 330 in FIGS. 8 to 10), and a transparent resin layer (e.g., the transparent resin layer 340 in FIGS. 5A and 5B, the transparent resin layer 440 in FIG. 8, the transparent resin layer 540 in FIG. 9, or the transparent resin layer 330 in FIG. 10). The first glass may be disposed corresponding to the first housing. The second glass may be disposed corresponding to the second housing. The protective layer may be disposed outside the first glass and the second glass. The transparent resin layer may be filled between the protective layer and the flexible display. The transparent resin layer may include plurality of first transparent areas (e.g., the first transparent areas 341 in FIGS. 5A and 5B, the first transparent areas 441 in FIG. 8, the first transparent areas 541 in FIG. 9, or the first transparent areas 341 in FIG. 10), and plurality of second transparent areas (e.g., the second transparent areas 342 in FIGS. 5A and 5B, the second transparent areas 442 in FIG. 8, the second transparent areas 542 in FIG. 9, or the second transparent areas 342 in FIG. 10). The plurality of first transparent areas may be spaced apart from each other in a direction from the first glass toward the second glass. The plurality of second transparent areas may be disposed between the plurality of first transparent areas. The maximum interval among the intervals between the plurality of first transparent areas may be 1.0 mm or less.

The minimum interval among the intervals between the plurality of first transparent areas may be 0.3 mm or more.

The transparent resin layer may include at least one of optically clear resin or optically clear adhesive. The transparent resin layer may include optically transparent resin. The transparent resin layer may include an optically transparent adhesive. The transparent resin layer may include an optically transparent resin and an optically transparent adhesive.

The first glass may include a first plane and a first inclined surface. The first inclined surface may be provided to face and slope toward the second glass. The second glass may include a second plane and a second inclined surface. The second inclined surface may be provided to face and slope toward the second glass.

According to an embodiment of the disclosure, the cover window (e.g., the cover window 300 in FIGS. 5A and 5B or the cover window 300 in FIGS. 8 to 10) may be configured to be laminated on one surface of the display (e.g., the display 230 in FIGS. 2 to 4). The cover window may include a first glass (e.g., the first glass 321 in FIGS. 5A and 5B, the first glass 321 in FIGS. 8 and 9, or the first glass 421 in FIG. 10), second glass (e.g., the second glass 322 in FIGS. 5A and 5B, the second glass 322 in FIGS. 8 and 9, or the second glass 422 in FIG. 10), a protective layer (e.g., the protective layer 330 in FIGS. 5A and 5B or the protective layer 330 in FIGS. 8 to 10), and a transparent resin layer (e.g., the transparent resin layer 340 in FIGS. 5A and 5B, the transparent resin layer 440 in FIG. 8, the transparent resin layer 540 in FIG. 9, or the transparent resin layer 330 in FIG. 10). The second glass may be spaced apart from the first glass. The second glass may be disposed corresponding to the second housing. The protective layer may be disposed outside the first glass and the second glass. The transparent resin layer may be configured to bond the first glass and the second glass to the protective layer. The transparent resin layer may include plurality of first transparent areas (e.g., the first transparent areas 341 in FIGS. 5A and 5B, the first transparent areas 441 in FIG. 8, the first transparent areas 541 in FIG. 9, or the first transparent areas 341 in FIG. 10), and plurality of second transparent areas (e.g., the second transparent areas 342 in FIGS. 5A and 5B, the second transparent areas 442 in FIG. 8, the second transparent areas 542 in FIG. 9, or the second transparent areas 342 in FIG. 10). The plurality of first transparent areas may be spaced apart from each other in a direction from the first glass toward the second glass. The hardness of the plurality of first transparent areas may be greater than hardness of the plurality of second transparent areas.

In the foregoing detailed description of this document, specific embodiments have been described. However, it will be evident to a person ordinarily skilled in the art that various modifications may be made without departing from the scope of the disclosure.

## Claims

1. An electronic device (101; 200) comprising:
a housing (202) comprising a first housing (210) and a second housing (220) configured to provide a relative movement with respect to the first housing;
a hinge structure (280) connecting the first housing and the second housing to be rotatable from a folded state to an unfolded state;
a flexible display (230) configured to vary in response to relative movement of the first housing with respect to the second housing; and
**characterized by**
a cover window (300) configured to cover an outer surface of the flexible display,
wherein the cover window comprises:
a first glass (321; 421) disposed corresponding to the first housing;
a second glass (322; 422) disposed corresponding to the second housing;
a protective layer (330) disposed outside the first glass and the second glass; and
a transparent resin layer (340; 440; 540) filled between the protective layer and the flexible display, wherein the transparent resin layer comprises a plurality of first transparent areas (341; 441; 541) spaced apart from each other in a direction from the first glass toward the second glass, and a plurality of second transparent areas (342; 442; 542) disposed between the plurality of first transparent areas, and
wherein a hardness of the plurality of first transparent areas is greater than a hardness of the plurality of second transparent areas.

2. The electronic device of claim 1, wherein, with reference to a folding axis (A) of the cover window, intervals between the plurality first transparent areas (341) gradually increase in a direction away from the folding axis.

3. The electronic device of any one of claims 1 and 2, wherein a maximum interval among the intervals between the plurality of first transparent areas is 1.0 mm or less.

4. The electronic device of any one of claims 1 to 3, wherein the first glass (341) and the second glass (342) are spaced apart from each other.

5. The electronic device of any one of claims 1 to 4, wherein the first glass (441) and the second glass (442) are integrally formed.

6. The electronic device of any one of claims 1 to 5, wherein, with reference to the folding axis (A) of the cover window, intervals between the plurality of first transparent areas (441) are arranged at equal intervals.

7. The electronic device of any one of claims 1 to 6, wherein, with reference to a folding axis (A) of the cover window, intervals between the plurality of first transparent areas (541) gradually decrease in a direction away from the folding axis.

8. The electronic device of any one of claims 1 to 7, wherein one of the plurality of second transparent areas is disposed on the folding axis (A) of the cover window.

9. The electronic device of any one of claims 1 to 8, wherein the flexible display comprises a first display area (231) disposed on the first housing, a second display area (232) disposed on the second housing, and a folding area (233) connecting the first display area and the second display area.

10. The electronic device of any one of claims 1 to 9, wherein, when the housing is in the folded state, at least some of the second transparent areas (342) disposed corresponding to the folding area are configured to be contract while remaining ones are configured to stretch.

11. The electronic device of any one of claims 1 to 10, wherein the hardness of the plurality of first transparent areas is 1.5 to 2.0 times the hardness of the plurality of second transparent areas.

12. The electronic device of one of claims 1 and 11, wherein the transparent resin layer comprises an optical clear resin.

13. The electronic device of any one of claims 1 and 12, wherein, in the first glass, a portion (321b) facing the second glass has a smaller thickness than another portion (321a), and
in the second glass, a portion (322b) facing the first glass has a smaller thickness than another portion (322a).

14. The electronic device of any one of claims 1 and 13, wherein the protective layer is a flexible thin glass.

15. The electronic device of any one of claims 1 and 14, wherein the transparent resin layer is configured to bond at least one of the first glass or the second glass to the protective layer and the display.

## Patentansprüche

1. Elektronische Vorrichtung (101; 200), umfassend:
ein Gehäuse (202), das ein erstes Gehäuse (210) und ein zweites Gehäuse (220) umfasst, das so konfiguriert ist, dass es eine Relativbewegung in Bezug auf das erste Gehäuse ermöglicht;
eine Scharnierstruktur (280), die das erste Gehäuse und das zweite Gehäuse verbindet, sodass sie von einem gefalteten Zustand in einen auseinandergefalteten Zustand gedreht werden können;
eine flexible Anzeige (230), die konfiguriert ist, um als Reaktion auf eine Relativbewegung des ersten Gehäuses in Bezug auf das zweite Gehäuse zu variieren; und
**gekennzeichnet durch**
ein Abdeckfenster (300), das konfiguriert ist, um eine Außenfläche der flexiblen Anzeige abzudecken,
wobei das Abdeckfenster Folgendes umfasst:
ein erstes Glas (321; 421), das entsprechend dem ersten Gehäuse angeordnet ist;
ein zweites Glas (322; 422), das entsprechend dem zweiten Gehäuse angeordnet ist;
eine Schutzschicht (330), die außerhalb des ersten Glases und des zweiten Glases angeordnet ist; und
eine transparente Harzschicht (340; 440; 540), die zwischen der Schutzschicht und der flexiblen Anzeige angeordnet ist, wobei die transparente Harzschicht eine Vielzahl von ersten transparenten Bereichen (341; 441; 541), die in einer Richtung vom ersten Glas zum zweiten Glas voneinander beabstandet sind, und eine Vielzahl von zweiten transparenten Bereichen (342; 442; 542) umfasst, die zwischen der Vielzahl der ersten transparenten Bereiche angeordnet sind, und
wobei eine Härte der Vielzahl von ersten transparenten Bereichen größer ist als eine Härte der Vielzahl von zweiten transparenten Bereichen.

2. Elektronische Vorrichtung nach Anspruch 1, wobei sich die Intervalle zwischen der Vielzahl von ersten transparenten Bereichen (341) in Bezug auf eine Faltachse (A) des Abdeckfensters in einer von der Faltachse wegführenden Richtung allmählich vergrößern.

3. Elektronische Vorrichtung nach einem der Ansprüche 1 und 2, wobei ein maximales Intervall zwischen den Intervallen der Vielzahl von ersten transparenten Bereichen 1,0 mm oder weniger beträgt.

4. Elektronische Vorrichtung nach einem der Ansprüche 1 bis 3, wobei das erste Glas (341) und das zweite Glas (342) voneinander beabstandet sind.

5. Elektronische Vorrichtung nach einem der Ansprüche 1 bis 4, wobei das erste Glas (441) und das zweite Glas (442) einstückig ausgebildet sind.

6. Elektronische Vorrichtung nach einem der Ansprüche 1 bis 5, wobei die Intervalle zwischen der Vielzahl von ersten transparenten Bereichen (441) in Bezug auf die Faltachse (A) des Abdeckfensters in gleichen Intervallen angeordnet sind.

7. Elektronische Vorrichtung nach einem der Ansprüche 1 bis 6, wobei sich die Intervalle zwischen der Vielzahl von ersten transparenten Bereichen (541) in Bezug auf eine Faltachse (A) des Abdeckfensters in einer von der Faltachse wegführenden Richtung allmählich verkleinern.

8. Elektronische Vorrichtung nach einem der Ansprüche 1 bis 7, wobei einer der Vielzahl von zweiten transparenten Bereichen auf der Faltachse (A) des Abdeckfensters angeordnet ist.

9. Elektronische Vorrichtung nach einem der Ansprüche 1 bis 8, wobei die flexible Anzeige einen ersten Anzeigebereich (231), der auf dem ersten Gehäuse angeordnet ist, einen zweiten Anzeigebereich (232), der auf dem zweiten Gehäuse angeordnet ist, und einen Faltbereich (233) umfasst, der den ersten Anzeigebereich und den zweiten Anzeigebereich miteinander verbindet.

10. Elektronische Vorrichtung nach einem der Ansprüche 1 bis 9, wobei, wenn sich das Gehäuse im gefalteten Zustand befindet, zumindest einige der zweiten transparenten Bereiche (342), die entsprechend dem Faltbereich angeordnet sind, so konfiguriert sind, dass sie sich zusammenziehen, während die übrigen so konfiguriert sind, dass sie sich dehnen.

11. Elektronische Vorrichtung nach einem der Ansprüche 1 bis 10, wobei die Härte der Vielzahl von ersten transparenten Bereichen das 1,5- bis 2,0-Fache der Härte der Vielzahl von zweiten transparenten Bereichen beträgt.

12. Elektronische Vorrichtung nach einem der Ansprüche 1 und 11, wobei die transparente Harzschicht ein optisch klares Harz umfasst.

13. Elektronische Vorrichtung nach einem der Ansprüche 1 und 12, wobei im ersten Glas ein dem zweiten Glas zugewandter Abschnitt (321b) eine geringere Dicke aufweist als ein anderer Abschnitt (321a), und
im zweiten Glas ein Abschnitt (322b), der dem ersten Glas zugewandt ist, eine geringere Dicke als ein anderer Abschnitt (322a) aufweist.

14. Elektronische Vorrichtung nach einem der Ansprüche 1 und 13, wobei die Schutzschicht ein flexibles dünnes Glas ist.

15. Elektronische Vorrichtung nach einem der Ansprüche 1 und 14, wobei die transparente Harzschicht konfiguriert ist, um mindestens eines des ersten Glases oder des zweiten Glases mit der Schutzschicht und der Anzeige zu verbinden.

## Revendications

1. Dispositif électronique (101 ; 200), comprenant :
un boîtier (202) comprenant un premier boîtier (210) et un deuxième boîtier (220) configuré pour permettre un mouvement relatif par rapport au premier boîtier ;
une structure de charnière (280) reliant le premier boîtier et le deuxième boîtier de manière à permettre leur rotation d'un état plié à un état déplié ;
un affichage flexible (230) configuré pour varier en réponse au mouvement relatif du premier boîtier par rapport au second boîtier ; et
**caractérisé par**
une fenêtre de recouvrement (300) configurée pour recouvrir une surface extérieure de l'affichage flexible,
dans lequel la fenêtre de recouvrement comprend :
un premier verre (321 ; 421) disposé en correspondance avec le premier boîtier ;
un second verre (322 ; 422) disposé en correspondance avec le second boîtier ;
une couche protectrice (330) disposée à l'extérieur du premier verre et du second verre ; et
une couche de résine transparente (340 ; 440 ; 540) remplie entre la couche protectrice et l'affichage flexible, la couche de résine transparente comprenant une pluralité de premières zones transparentes (341 ; 441 ; 541) espacées les unes des autres dans une direction allant du premier verre vers le second verre, et une pluralité de secondes zones transparentes (342 ; 442 ; 542) disposées entre la pluralité de premières zones transparentes, et
dans lequel la dureté de la pluralité de premières zones transparentes est supérieure à la dureté de la pluralité de secondes zones transparentes.

2. Dispositif électronique de la revendication 1, dans lequel, par rapport à un axe de pliage (A) de la fenêtre de recouvrement, les intervalles entre la pluralité de premières zones transparentes (341) augmentent progressivement dans une direction s'éloignant de l'axe de pliage.

3. Dispositif électronique de l'une quelconque des revendications 1 et 2, dans lequel l'intervalle maximal parmi les intervalles entre la pluralité de premières zones transparentes est de 1,0 mm ou moins.

4. Dispositif électronique de l'une quelconque des revendications 1 à 3, dans lequel le premier verre (341) et le deuxième verre (342) sont espacés l'un de l'autre.

5. Dispositif électronique de l'une quelconque des revendications 1 à 4, dans lequel le premier verre (441) et le deuxième verre (442) sont formés intégralement.

6. Dispositif électronique de l'une quelconque des revendications 1 à 5, dans lequel, par rapport à l'axe de pliage (A) de la fenêtre de recouvrement, les intervalles entre la pluralité de premières zones transparentes (441) sont disposés à intervalles égaux.

7. Dispositif électronique de l'une quelconque des revendications 1 à 6, dans lequel, par rapport à un axe de pliage (A) de la fenêtre de recouvrement, les intervalles entre la pluralité de premières zones transparentes (541) diminuent progressivement dans une direction s'éloignant de l'axe de pliage.

8. Dispositif électronique de l'une quelconque des revendications 1 à 7, dans lequel l'une de la pluralité de deuxièmes zones transparentes est disposée sur l'axe de pliage (A) de la fenêtre de recouvrement.

9. Dispositif électronique de l'une quelconque des revendications 1 à 8, dans lequel l'affichage flexible comprend une première zone d'affichage (231) disposée sur le premier boîtier, une deuxième zone d'affichage (232) disposée sur le deuxième boîtier, et une zone de pliage (233) reliant la première zone d'affichage et la deuxième zone d'affichage.

10. Dispositif électronique de l'une quelconque des revendications 1 à 9, dans lequel, lorsque le boîtier est à l'état plié, au moins certaines des deuxièmes zones transparentes (342) disposées en correspondance avec la zone de pliage sont configurées pour se contracter, tandis que les autres sont configurées pour s'étirer.

11. Dispositif électronique de l'une quelconque des revendications 1 à 10, dans lequel la dureté de la pluralité de premières zones transparentes est comprise entre 1,5 et 2,0 fois la dureté de la pluralité de secondes zones transparentes.

12. Dispositif électronique de l'une des revendications 1 et 11, dans lequel la couche de résine transparente comprend une résine optiquement transparente.

13. Dispositif électronique de l'une quelconque des revendications 1 et 12, dans lequel, dans le premier verre, une partie (321b) faisant face au deuxième verre présente une épaisseur inférieure à celle d'une autre partie (321a), et
dans le second verre, une partie (322b) faisant face au premier verre présente une épaisseur inférieure à celle d'une autre partie (322a).

14. Dispositif électronique de l'une quelconque des revendications 1 et 13, dans lequel la couche protectrice est un verre mince et souple.

15. Dispositif électronique de l'une quelconque des revendications 1 et 14, dans lequel la couche de résine transparente est configurée pour fixer au moins un du premier verre ou du deuxième verre à la couche protectrice et à l'affichage.
